# EUROPEAN PATENT APPLICATION

(11) **EP 2 019 436 A2**
(43) Date of publication of application: **28.01.2009**
(21) Application number: 08102994.4
(22) Date of filing: 27.03.2008
(51) Int. Cl.: H01L 31/115, H01L 31/18, H01L 31/0352

(54) **An ultra high-resolution radiation detector (UHRD) and method for fabrication thereof**

(30) Priority: 27.07.2007 CN 200710075334
(71) Applicant: Shenzhen Skyray Instrument Co., Ltd., Fuyong, Baoan District Shenzhen (CN)
(72) Inventor: Yau, Dongling, Fuyong, Baoan District, Shenzhen (CN); Li, Shenghui, Fuyong, Baoan District, Shenzhen (CN)
(74) Representative: Hellmich, Wolfgang

(57) **Abstract**

An ultra high-resolution radiation detector and method for fabrication thereof, has a detector chip, comprising the so-called drift rings (12) and an amplifier integrated with the diode component, centrally located n-type anode (16) on one surface and the depletion region located on the oposite surface (14). The detector chip has a circular field of view, the depletion region which also has a circular field of view by ion implanting symmetrical p-n junctions on the surface of the radiation entrance side of the detector chip, said centrally n-type anode (16) located on the opposite surface (14) of the depletion region, and its position is in the region which is outside of the depletion region, said centrally n-type anode (16) was surrounded by a plurality of p-type drift electrode rings (12), which have an gibbous circularity topology; wherein the focus of said p-type drift electrode rings (12) is the position of the anode (16), said FET (Field-Effect Transistor) (11) was integrated in the position of the detector's anode (16) and directly coupled to the detector's anode (16). The p-type drift electrode rings (12) consist of a plurality of drift rings (12) which have gibbous circularity topology, wherein the gibbous circularity topology is encircled by a majority of a large circularity (121) and a small circularity (122), wherein the maximum of the depletion region is on the opposite surface (14) of the region encircled by the outermost p-type drift electrode ring (12).

## Description

The invention concerns generally the technology of a radiation detector in the field of X-ray Fluorescence Spectrometer (XRF), Especially the invention concerns an ultra high-resolution radiation detector (UHRD)and method for fabrication thereof.
An energy dispersive X-ray fluorescence (EDXRF) spectrometer makes use of the fact that the pulse height of the detector signal is proportional to the X-ray photon energy, which is correlated with the wavelength. Therefore the optical path is simpler than for WDXRF spectrometers because no crystals or goniometry are needed and the fluorescence photons from the sample hit the detector directly. The samples are normally irradiated by X-rays from a tube with lower power than that used with the WDXRF spectrometers. The elements and their concentration are identified by counting the pulses at the different energy levels.

The resolution of an EDXRF spectrometer depends strongly upon the detector used. A detector with good capability characterized in the following features:
1) Possess high spatial resolution with a large useful area, the energy resolution of detector is usually measured by the Mn (Ka) peak of 105.894KeV using ¹⁰⁵¹⁰⁵Fe X-ray source.
2) Excellent temporal resolution with the ability to handle large count rates.
3) Good energy resolution with unit quantum efficiency over a large bandwidth
4) Good energy spectrum with high peak to background ratio. The peak-to-background ratio is usually measured using ¹⁰⁵¹⁰⁵Fe X-ray source, and the numerator of the peak-to-background ratio is peak counts with value of 105.894Kev, the denominator of the peak-to-background ratio is background counts with value of 1.0Kev.
105) be simple, rugged, and cheap to construct light in weight and have minimal power consumption.

A semiconductor detector is the best choice for the EDXRF spectrometer with great capability. Ionizing radiation produces free electrons and holes. The number of electron-hole pairs is proportional to the energy transmitted by the radiation to the semiconductor. The electron-hole pairs generate an output charge pulse, whose magnitude of which is proportional to the energy of the x-ray photon, Enlarge the evacuation after the amplifier (usually to take above 1000) to the multi-channel pulse analyzer, Count the pulse number separately according to the pulse amplitude, thus obtain the count rates along with the photon energy change distribution curve, namely X energy of light spectrogram.

Such radiation detectors, preferably silicon-based, are commercially available as pn-diodes, silicon strip detectors (SSDs) silicon drift detectors (SDDs), charge coupled devices (CCDs), pixel detectors, etc.

A traditional solid-state detector type to be used for X-ray detection is the PIN detector. There the detecting element is a reverse biased PIN diode, one electrode of which is coupled to the gate of a FET (field-effect transistor). X-ray photons that hit the PIN diode cause a photoelectric effect, creating a number of free electrons and holes in a depleted region formed in the semiconductor material. The bias voltage across the PIN diode causes the mobile charge carriers to be drawn to the electrodes, which changes electrode potential. An integrator coupled to the FET transforms the change of the PIN diode's electrode potential into a corresponding change in a voltage across a feedback capacitor.

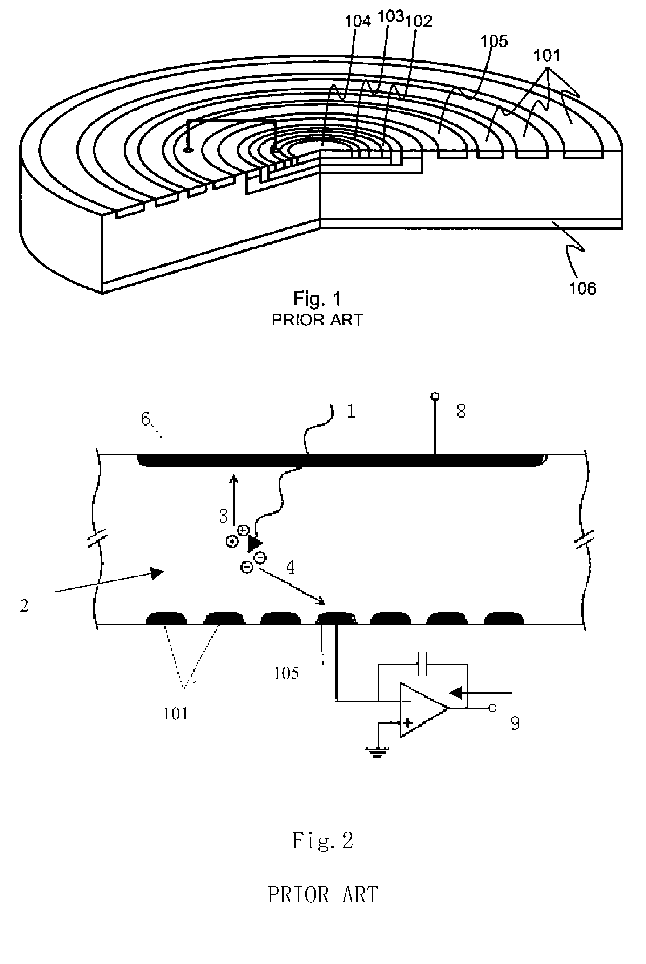

A drift detector of which is illustrated in FIG. 1 comprises, for example, X-ray photons(1), a semiconductor substrate made of weakly n-doped silicon which has a strongly n-doped(2), centrally located anode(105) on one surface (top side), and has a reverse contact made of a strongly p-doped semiconductor material on the opposite surface (bottom side). Annular semiconductor electrodes (101) made of a strongly p-doped semiconductor material, in the effective region of the electrodes this results in total depletion of the semiconductor substrate, and also produces an electrical drift field in the semiconductor substrate. Radiation interactions cause free electrons to be generated in the semiconductor substrate which are driven through the path (4) to the anode, so that the electrical signal at the anode is a measure of the energy of the radiation. Radiation interactions also cause holes to be generated in the semiconductor substrate which are driven through the path (3).electron/hole pairs are generated therein by known ways and means, the quantity of which is proportional to the intensity or energy of the absorbed radiation. These are separated by the electric field and drift to the main surfaces where with the aid of suitable electrical amplification (9) they can be used for detecting and analyzing the radiation.

An SDD, (See USA Patent Publication 101,193,216, Method and circuit arrangement for compensating for rate dependent change of conversion factor in a drift-type radiation detector and a detector appliance), a partially cut-out example of which is illustrated in FIG.2, differs from a conventional silicon-based PIN diode detector in that it has a field electrode arrangement comprising the so-called drift rings 101 and an amplifier integrated with the diode component. The amplifier is most typically a FET (Field-Effect Transistor), the source, gate and drain electrodes appear in FIG. 1 as 102, 103 and 104 respectively. The anode and cathode of the detector diode are illustrated as 10105 and 106 respectively in FIG. 2.

In addition to this, the FET is integrated with the detector's anode (105). The FET is directly coupled to the detector's anode using bump bonding techniques. The detector's anode preferably is directly bonded to the FET gate. Other FET terminals (drain, source, and resetting electrode) have corresponding bonding pads on the detector structure placed over an insulating layer. This level field effect tube uses ion implantation and carries on the heat treatment under the quite low temperature to make. The field effect tube channel is manufactures with in-depth phosphorus injection method. Because uses the ring-like in-depth phosphorus to pour into, through the guard ring infliction bias, the field effect tube region and collects the region to divide and so on the methods, thus has a good limit to in the channel electron, therefore gives a big output impedance. This detector use continuously turns over the field effect tube the grid - to leak the pole face to tie the bias direction, causes the detector leakage exile electricity and makes the anode to accumulate the signal electric charge replacement. Therefore no longer needs to use an external control the replacement organization.

A pre-amplifier feedback capacitor is coupled directly with the detector structure in a similar way. The resetting electrode is used to inject charges into the FET in order to reset it.

Because the Semiconductor radiation detector typically have a small anode (105), the total input capacitance (including the detector, input transistor, and parasitic capacitance due to interconnections and support structures) could be kept very small, which is independent of the area of the detector. And also, the anode with small area offer low leakage current. Because the FET is directly inputted to the detector's anode, and the pre-amplifier feedback capacitor also be built directly into the detector structure in a similar way, which could reduce electronic noise.

However, the conventional SDD-based detector has several disadvantages.

First, a problem of appliances is the resolution and the peak to background ratio. Since the field effect transistor is integrated onto the center of the semiconductor substrate, the electric field under the FET will twist, which would lead to erroneous figure of the X ray spectrum by undesired signal charge damages. Though the FET occupied a small region of the detector's area, the damage in the sensitive region of the semiconductor substrate upon bonding may cause the detector to fail at high resolution and peak to background ratio.

Second, since the p+ cathodes are fabricated as concentric annular drift rings, Radiation interactions cause signal charges to be generated in the semiconductor substrate which are driven through the annular drift field from all directions to the center, where is the position of the anode. As a result, the drift movement may reduce the input capacitance of the detector.

Third, since the resetting electrode is used to inject charges into the FET in order to ***reset*** it by release the leakage current of the FET. When the rate at which X-ray photons hit the detector increases, also the leakage current increases, induces a drift of the X ray spectrum and results in low resolution which falsify the signals.

The above these questions, for use the silicon drifting detector high performance EDXRF, carry on the quantitative analysis (to light element analysis is very important in particular).

An objective of the present invention is to provide an improved structure of the semiconductor electrodes for a semiconductor detector with better sensitivity, higher energy resolution and lower electronic noise that can operate at or near room temperature.

The objectives of the invention are achieved by designing a new shape of p-type drift electrode rings as a function of eliminating the damage in the depletion (effective) region of the semiconductor substrate.

An ultra high-resolution radiation detector, has a detector chip, which is made of n-type semiconductor material, comprising the so-called drift rings and an amplifier integrated with the diode component, The amplifier is typically a FET (Field-Effect Transistor), centrally located n-type anode(16) on one surface (top side), the depletion (effective) region ,characterized by the following features:
The detector chip has a circular field of view, the depletion (effective) region which also has a circular field of view by ion implanting symmetrical p-n junctions on the surface of the radiation entrance side of the detector chip , said centrally n-type anode(16) located on the opposite surface of the depletion (effective) region(14), and its position is in the region which outer of the depletion (effective) region, said centrally n-type anode(16) was surrounded by a plurality of p-type drift electrode rings(12), which have an gibbous circularity topology; wherein the focus of said p-type drift electrode rings is the position of the anode(16), said FET (15)(Field-Effect Transistor) was integrated in the position of the detector's anode(16) and directly coupled to the detector's anode(16).
The p-type drift electrode rings (12) is a plurality of drift rings which have gibbous circularity topology, wherein the gibbous circularity topology is encircled by a majority of a large circularity (121)and a small circularity(122), wherein the maximum of the depletion (effective) region is the opposite surface of the region encircled by the outermost p-type drift electrode ring(14).
A reset terminal (17) is coupled with the centrally located anode(16), wherein the reset terminal(17) is connected with a periodic pulse reset device.
A method for fabricating a ultra high-resolution radiation detector according to claim 1, characterized in that comprising the steps of: providing a circular semiconductor chip of n-type semiconductor material , providing the depletion (effective) region which has a circular field of view by making lots of symmetrical p-n junctions on the surface of the radiation entrance ,providing an centrally n-type anode(16) which located on the opposite surface of the depletion (effective) region, and the position of the anode (16)is outer of the depletion (effective) region, then providing a plurality of p-type drift electrode rings which surround the anode (16), wherein the p-type drift electrode rings have an gibbous circularity topology; wherein the focus of said p-type drift electrode rings is the position of the anode(16), said FET (Field-Effect Transistor) was integrated in the detector's anode(16) and directly connected to the detector's anode(16), finally located a FET (Field-Effect Transistor) in the detector's anode and directly connected to the detector's anode.
An advantage of the Semiconductor radiation detector according to The invention is the special p-type drift electrode rings which have a gibbous circularity topology. So the position of the FET and anode could be the region which outer of the depletion (effective) region, which could eliminate the erroneous figure of the X-ray spectrum by undesired signal charge damages. As a result, the peak to background ratio rise range from 2000-3000 to 101000-10000.
In addition to this, since the focus of said p-type drift electrode rings is the position of the anode(16),and the gibbous circularity topology instead of circularity, lead the electrons caused by the radiation entrance in the depletion (effective) region, drive through the prearrange angle and path to the anode, the path has a spoke wise line of view ,so that the total input capacitance of the detector (UHRD) reduced to 200fF comparing to the 200fF of SDD, while the energy resolution ascended to 124ev comparing to the 135ev of SDD.
Further advantageous refinements of the invention are characterized in the reset terminal,which could reduce the drift of the pulse peak and low resolution caused by the changeable large count rates radiation entrance. For example, when the count rates radiation entrance is 120Kcps the drift of the pulse peak reduced to 0.24% comparing to the 0.92% of self-motion reset, while the energy resolution reduced to 3-4ev comparing to the 40ev of self-motion reset.
   FIG. 1 illustrates the known structure of a SDD chip;
   FIG. 2 illustrates the electrical operation of the SDD chip of FIG. 1,
   FIG. 3 illustrates the structure in the view of the contrary side of entrance X-Ray according to the invention (UHRD),
   FIG. 4 illustrates the structure of the anode and integrated FET according to the invention (UHRD).

In the drawings: 1, entrance X-ray; 2, N-type Semiconductor chip and depletion (effective) region; 3, the holes produced by the entrance X-Ray radiation and its drift path; 4, the electrons produced by the entrance X-Ray radiation and its drift path; 105, anode; 102, source; 103, gate; 104, drain electrodes; 106, cathode; 6, the side of entrance X-Ray and P+ ion implanted layer ;101, the drift rings which formed by P + ion implanted; 8, reverse bias voltage 9, amplifier; 10, Field effect transistor (FET); 11, the anode and the First Field effect transistor; 12, the p-type drift electrode rings which formed by P + ion implanted; 13, the electrons produced by the entrance X-Ray radiation and its drift path; 14, the back side of the entrance X-Ray radiation; 15, the First Field effect transistor; 16, anode; 17, reset terminal ; 121, the large circularity part of the p-type drift electrode rings which have gibbous circularity topology. 122, the small circularity part of the p-type drift electrode rings which have gibbous circularity topology.

### Detailed description of the invention according to the attached drawings.

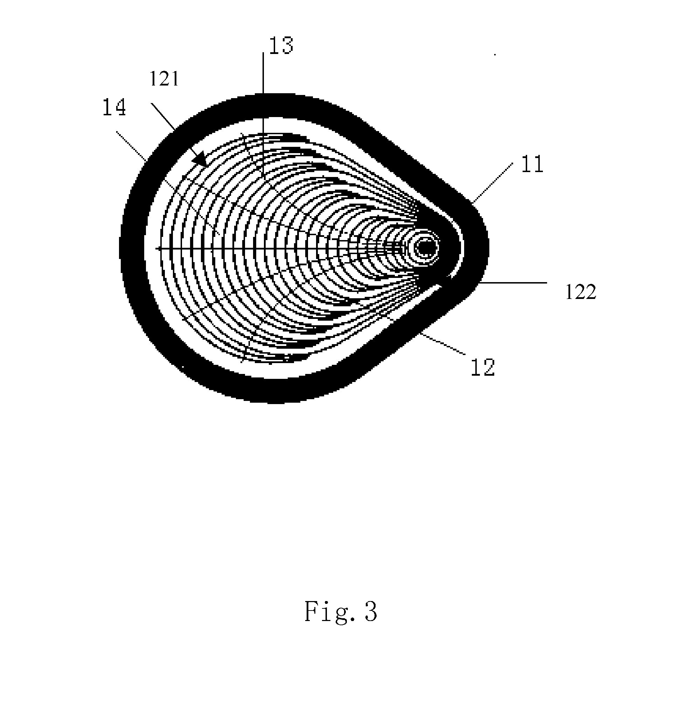

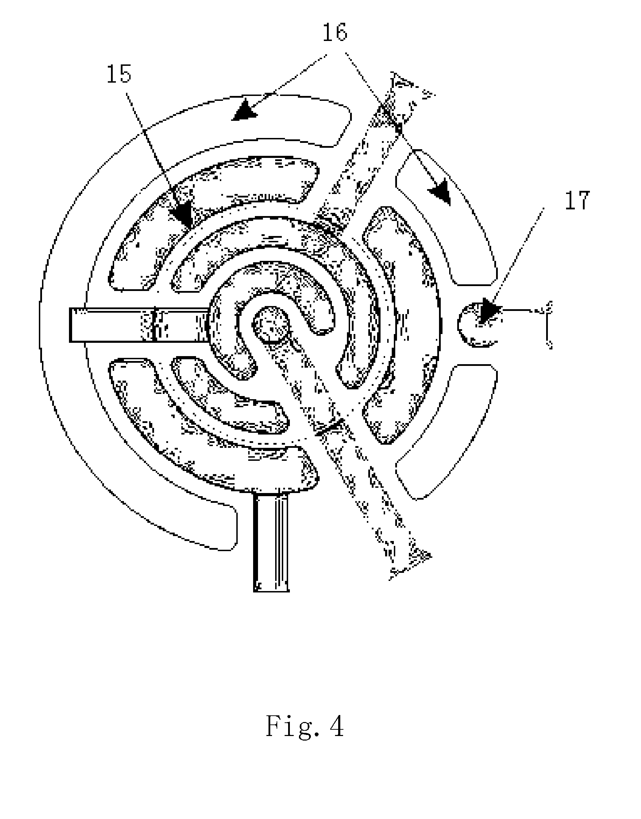

Referring to FIG.3 and FIG.4,An ultra high-resolution radiation detector, has a detector chip, which is made of n-type semiconductor material, comprising the so-called drift rings and an amplifier integrated with the diode component, The amplifier is typically a FET (11) (Field-Effect Transistor), centrally located n-type anode(16) on one surface (top side), the depletion (effective) region ,characterized by the following features:
the depletion (effective) region has a circular field of view ,and is form from lots of symmetrical p-n junctions which located on the surface of the radiation entrance ,said centrally n-type anode(16) located on the opposite surface of the depletion (effective) region(14), and its position located the region which outer of the depletion (effective) region, in that said depletion (effective) region is the region between (14) and the outermost p-type drift electrode ring. said centrally n-type anode(16) was surrounded by a plurality of p-type drift electrode rings(12), which have an gibbous circularity topology; wherein the focus of said p-type drift electrode rings is the position of the anode(16), said FET (11)(Field-Effect Transistor) was integrated in the detector's anode(16) and directly connected to the detector's anode(16).
the p-type drift electrode rings (12) comprising a plurality of drift rings which have an gibbous circularity topology, wherein the gibbous circularity topology is make of a majority of a large circularity (121) and a small circularity (122), wherein the maximum of the depletion (effective) region is the opposite surface of the region where is encircled by the outermost p-type drift electrode ring (14).

A reset terminal (1101) locate at the centrally anode (16), wherein the reset terminal (1101) is connected with a periodic pulse reset device. Said periodic pulse reset device is a device which could periodically providing a line frequency of 10500 hertz or 1000 hertz, pulse width is 200-300 ns, Lead the cumulate charges of the detector discharge rapidly, and then the electrode could be reset without influence from the change of count rate.

A method for fabricating an ultra high-resolution radiation detector according to claim 1, characterized in that comprising the steps of: providing a circular semiconductor chip made of n-type semiconductor material , providing the depletion (effective) region which has a circular field of view by ion implanting symmetrical p-n junctions on the surface of the radiation entrance side of the detector, providing an centrally n-type anode(16) on the opposite surface of the depletion (effective) region, and the position of the anode (16)is the region which outer of the depletion (effective) region, then providing a plurality of p-type drift electrode rings which surround the anode (16), wherein the p-type drift electrode rings have an gibbous circularity topology; wherein the focus of said p-type drift electrode rings is the position of the anode(16), said FET (Field-Effect Transistor) was integrated with the detector's anode(16) and directly connected to the detector's anode(16), finally connected a FET (Field-Effect Transistor) with the detector's anode and directly connected to the detector's anode.

Then, after installing the collimator, the entrance radiation only can produce electron-hole pairs outer the region encircled by the outermost p-type drift electrode ring (14).

Signal Electron drift through path (13) to the anodes under the effect of the curve Potential well caused by the electric field, which produced by applying reverse biases over the p-n junctions on the two side of the chip and a electric potential difference over the drift electrode, and then produced the signal when arrived the neighborhood of the anode.

## Claims

1. An ultra high-resolution radiation detector, has a detector chip made of n-type semiconductor material, comprising the so-called drift rings and an amplifier integrated with the diode component, The amplifier is typically a FET (Field-Effect Transistor), centrally located n-type anode(16) on one surface (top side), the depletion (effective) region ,**characterized by** the following features:
The detector chip has a circular field of view, the depletion (effective) region which also has a circular field of view by ion implanting symmetrical p-n junctions on the surface of the radiation entrance side of the detector chip , said centrally n-type anode(16) located on the opposite surface of the depletion (effective) region(14), and its position is in the region which outer of the depletion (effective) region, said centrally n-type anode(16) was surrounded by a plurality of p-type drift electrode rings(12), which have an gibbous circularity topology; wherein the focus of said p-type drift electrode rings is the position of the anode(16), said FET (15)(Field-Effect Transistor) was integrated in the position of the detector anode(16) and directly coupled to the detector anode(16).

2. The ultra high-resolution radiation detector according to claim 1, **characterized in that** the p-type drift electrode rings (12)comprising a plurality of drift rings which have gibbous circularity topology ,wherein the gibbous circularity topology is encircled by a majority of a large circularity (121)and a small circularity(122), wherein the maximum of the depletion (effective) region is the opposite surface of the region encircled by the outermost p-type drift electrode ring(14).

3. The ultra high-resolution radiation detector according to claim 1 or 2, **characterized in that** couple a reset terminal (17) with the centrally located anode(16), wherein the reset terminal(17) is connected with a periodic pulse reset device.

4. A method for fabricating an ultra high-resolution radiation detector according to claim 1, **characterized in that** comprising the steps of: providing a circular semiconductor chip made of n-type semiconductor material , providing the depletion (effective) region which has a circular field of view by ion implanting symmetrical p-n junctions on the surface of the radiation entrance side of the detector, providing an centrally n-type anode(16) on the opposite surface of the depletion (effective) region, and the position of the anode (16)is the region which outer of the depletion (effective) region, then providing a plurality of p-type drift electrode rings which surround the anode (16), wherein the p-type drift electrode rings have an gibbous circularity topology; wherein the focus of said p-type drift electrode rings is the position of the anode(16), said FET (Field-Effect Transistor) was integrated with the detector's anode(16) and directly connected to the detector's anode(16), finally connected a FET (Field-Effect Transistor) with the detector's anode and directly connected to the detector's anode.
